# FASCICULE DE BREVET EUROPEEN

(11) **EP 2 478 566 B1**
(45) Date de publication et mention de la délivrance du brevet: **16.10.2013**
(21) Numéro de dépôt: 10754589.9
(22) Date de dépôt: 26.08.2010
(51) Int. Cl.: H01L 31/0224, H01L 21/3213

(54) **PROCÉDÉ DE RÉALISATION D'UNE STRUCTURE EN PLOTS RÉGULIÈREMENT ESPACÉS**
VERFAHREN ZUR BILDUNG EINER STRUKTUR AUF KONTAKTEN MIT REGELMÄSSIGEN ABSTÄNDEN
METHOD FOR PRODUCING A STRUCTURE ON REGULARLY SPACED CONTACTS

(30) Priorité: 18.09.2009 FR 0956447
(43) Date de publication de la demande: 25.07.2012
(73) Titulaire: Commissariat à l'Énergie Atomique et aux Énergies Alternatives, 75015 Paris (FR)
(72) Inventeur: GARANDET, Jean-Paul, F-73370 Le Bourget Du Lac (FR); JULIET, Pierre, F-38000 Grenoble (FR)
(74) Mandataire: Le Coupanec, Pascale A.M.P.
(86) Numéro de dépôt international: PCT/IB2010/053847
(87) Numéro de publication internationale: WO 2011/033408

(56) Documents cités:
- US-A- 4 751 191

## Description

La présente invention a pour objet un procédé de réalisation d'une structure particulière de plots à la surface d'un substrat.

L'invention s'applique notamment, mais non exclusivement, à la réalisation de substrats pour des applications en microélectronique et dans le domaine photovoltaïque pour l'obtention de structures régulières de plots, par exemple à base d'un siliciure métallique, pouvant servir de germes pour le contrôle de la recristallisation d'une couche mince de silicium.

Le document US 4751191 decrit la formation d'une cellule solaire.

Il est connu, pour recristalliser des couches minces de silicium dans le domaine photovoltaïque, de mettre en oeuvre un processus de nucléation des cristaux de silicium aléatoire et ayant pour base une statistique décrivant les fluctuations de la phase amorphe du silicium.

Toutefois, cet aspect aléatoire peut poser des problèmes en termes de limitation et de dispersion de tailles des grains après une étape de recuit de cristallisation.

Pour remédier aux problèmes mentionnés ci-dessus, il a été proposé d'utiliser des germes servant de base au processus de nucléation, de tels germes pouvant être obtenus par un réseau de plots ménagé sur la surface d'un substrat.

Il est connu, pour réaliser un substrat portant un tel réseau de plots, de déposer une couche d'un matériau sur un lit de billes préalablement déposé, par exemple par trempage, sur la surface d'un substrat et d'éliminer ensuite le lit de billes pour obtenir un réseau régulier de plots du matériau.

Le lit de billes déposé sur le substrat définit un motif présentant des zones évidées dans lesquelles la couche de matériau est susceptible d'être accumulée, formant ainsi des ilots. En conséquence, la taille des plots qui sont formés à partir des îlots de matériau formés dans les zones évidées est proportionnelle à la taille des billes, ce qui peut nuire, voire rendre impossible, l'obtention de plots de taille nanométrique à des distances micrométriques.

Pour décorréler la taille des plots obtenus et la taille des billes, il est connu de déposer sur le substrat une couche de résine photosensible de type positif, c'est-à-dire une couche de résine photosensible pour laquelle le rayonnement produit une réaction chimique des macromolécules entrainant une solubilité accrue des zones exposées dans un révélateur et d'insoler cette couche, par exemple en mettant en oeuvre la technique de lithographie à faisceau d'électrons (encore appelée *e-beam*). Après dissolution des zones insolées dans le révélateur, un dépôt pleine plaque du matériau destiné à former les plots peut être réalisé. La couche de résine peut alors être éliminée, par exemple en mettant en oeuvre une technique additive utilisant un matériau sacrificiel, en particulier la technique *lift-off.*

Malheureusement, un processus utilisant la technologie *e-beam* peut être relativement complexe et coûteux à mettre en oeuvre.

Il existe donc un besoin pour bénéficier d'un procédé permettant la fabrication d'une structure régulière de plots de taille nanométrique à la surface d'un substrat, notamment pour des applications microélectroniques ou dans le domaine photovoltaïque qui permet de s'affranchir des limitations exposées ci-dessus.

L'invention a précisément pour objet de répondre à ce besoin et elle y parvient, selon l'un de ses aspects, grâce à un procédé de réalisation, à la surface d'au moins une face d'un substrat, d'une structure régulière de plots dans laquelle lesdits plots sont disposés de manière non contigüe et possèdent une taille au moins dix fois inférieure à la taille de l'espacement entre deux plots voisins de ladite structure, le procédé comportant au moins les étapes suivantes :
a) disposer d'un substrat doté en surface d'au moins l'une de ses faces d'une structure régulière de plots,
b) soumettre ladite structure figurant sur le substrat à une gravure anisotrope en présence d'un plasma directif de façon à réduire la quantité de matière de chaque plot, et
c) soumettre ladite structure à un traitement thermique à une température comprise entre T_{f}-200 °C et T_{f}-50 °C, T_{f} étant la température de fusion des plots.

Par « taille de l'espacement entre deux plots voisins de la structure », on entend désigner au sens de l'invention la dimension moyenne mesurée entre deux plots consécutifs, par exemple par analyse d'image au MEB.

Par « structure régulière », on désigne un ensemble de plots disposé en surface d'un substrat et dont l'écart-type sur la taille de l'espacement entre les plots est inférieur à 10 %, par exemple à 5 %, de ladite taille de l'espacement. Cet écart-type est par exemple mesuré par analyse d'image au microscope électronique à balayage (MEB).

Par « taille de plot », on entend désigner au sens de l'invention la largeur moyenne de la section horizontale la plus élevée d'un plot mesurée par exemple par analyse d'image au MEB.

Les expressions « compris entre... et... », « allant de ... à ... » et « variant de ... à ...» sont équivalentes et entendent signifier que les bornes sont incluses, sauf mention contraire.

Contre toute attente, les inventeurs ont constaté que l'on pouvait, par gravure anisotrope en présence d'un plasma directif, réduire la quantité de matière des plots d'un facteur supérieur à quatre sans éliminer totalement la matière des plots.

L'invention peut ainsi permettre de contrôler avec précision la quantité de matière enlevée lors de l'étape de gravure anisotrope, notamment jusqu'à ce que la taille ou encore l'épaisseur du plot soit par exemple de l'ordre du nanomètre.

Plus précisément, la quantité de matière de chaque plot peut être réduite de façon à ce que le rapport entre ladite quantité avant gravure anisotrope et ladite quantité après gravure anisotrope soit supérieur à cinq, étant notamment supérieur à dix.

L'invention permet ainsi d'obtenir un rapport (taille de l'espacement entre deux plots voisins dans la structure)/ (taille d'un plot) qui est supérieur ou égal à 25, notamment à 50, notamment à 100, à 500, voire à 1000, et donc d'accéder à une différence importante entre la taille des plots et la distance entre ces plots sur le substrat.

Les plots ainsi obtenus peuvent présenter une taille comprise entre 5 et 500 nm, notamment entre 20 et 500 nanomètres, notamment entre 40 et 100 nanomètres, et notamment entre 50 et 100 nm.

La taille de l'espacement entre deux plots voisins peut être comprise entre 0,1 et 500 micromètres, notamment entre 2 et 50 micromètres, entre 2 et 10 micromètres, et notamment entre 5 et 10 micromètres.

Le matériau constituant les plots peut être déposé avant l'étape a) sur un lit de billes placé sur le substrat, ledit lit de billes définissant un motif présentant des zones évidées.

L'invention peut ainsi permettre de combiner :
- d'une part les caractéristiques de l'étape de dépôt sur le substrat d'un matériau destiné à former les plots et les caractéristiques de l'étape de gravure anisotrope et,
- d'autre part les caractéristiques de l'étape de gravure anisotrope et les caractéristiques de l'étape d'échauffement thermique de la structure après gravure anisotrope.

L'invention a encore pour objet, selon un autre de ses aspects, un substrat comportant une structure régulière de plots obtenue à l'aide du procédé tel que défini ci-dessus, lesdits plots présentant une taille au moins dix fois inférieure à la taille de l'espacement entre deux plots voisins de la structure.

### Etape de gravure anisotrope

L'étape de gravure anisotrope peut être mise en oeuvre à l'aide d'un plasma directif de gaz neutre ou d'hydrogène. Selon un mode préféré, le gaz neutre est l'argon. Le plasma directif est par exemple dirigé normalement au substrat.

Les inventeurs ont constaté que l'efficacité de l'enlèvement de matière par le plasma directif était augmentée lorsque le plasma directif travaille en incidence oblique plutôt qu'en incidence normale, configuration que l'on obtient, notamment dans un mode préféré, lorsque le faisceau est normal au substrat.

Lorsque les flancs des plots présentent une ou plusieurs portions obliques, comme mentionné ci-dessus, l'anisotropie de la gravure permet de lisser les flancs des plots, la matière desdites portions obliques étant alors enlevée, de manière à ce que les plots aient par exemple une forme proche du cylindre à l'issue de l'étape de gravure anisotrope.

Lorsque la forme désirée, par exemple la forme de cylindre précitée, a été atteinte pour les plots, le processus de gravure peut devenir autolimitant, étant donné que seules les faces normales à la direction du plasma demeurent principalement.

Comme il ressort de ce qui précède, l'invention peut être mise en oeuvre sans recours aux techniques de gravage mécanique ou aux techniques de type microplasturgie.

L'étape d'échauffement thermique des plots de la structure permet de regrouper la matière déposée en forme de calotte sphérique de rayon par exemple inférieur à 100 nanomètres, la mise en oeuvre de cette étape d'échauffement thermique étant facilitée par la réduction de la taille des plots à l'issue de l'étape de gravure anisotrope.

Cette étape d'échauffement correspond par exemple à un recuit de déstabilisation des plots et, notamment lorsque le matériau est du siliciure, peut permettre une sphéroïdisation des plots et la cristallisation du siliciure.

Lorsque le substrat portant la structure est monocristallin, cette étape d'échauffement peut favoriser l'obtention d'une structure de plots cristallins de même orientation.

### Plots

En ce qui concerne le matériau formant les plots, il s'agit avantageusement d'un siliciure, par exemple du siliciure métallique.

Il s'agit par exemple d'un siliciure d'un métal choisi parmi Fe, Co, Mn, Ni, Ti, V et leurs mélanges.

Selon un mode préféré de réalisation, le germe sera choisi parmi le siliciure de nickel NiSi₂ et le siliciure de cobalt CoSi₂. Ces matériaux ont un paramètre de maille qui favorise la germination des cristaux de silicium.

Ces plots peuvent être formés sur le substrat selon des techniques conventionnelles, préalablement à la mise en oeuvre de l'étape b).

Ainsi, le matériau déposé sur le substrat pour former les plots peut être déposé à l'aide d'une cible synthétisée à partir d'un mélange de poudres frittées, ce qui peut s'avérer avantageux lorsque des cibles pré-synthétisées destinées à être utilisées pour former les plots ne sont pas disponibles.

La couche du matériau destiné à former les plots de la structure peut être déposée sur un lit de billes placé sur le substrat, ledit lit de billes définissant un motif présentant des zones évidées.

La couche du matériau peut être déposée sur le lit de billes par dépôt physique en phase vapeur, la vapeur étant par exemple produite par évaporation ou pulvérisation.

Du fait de la présence du lit de billes, la surface du substrat est en grande partie masquée par les billes. Les effets d'ombrage et de relief dus à ces dernières peuvent conférer une forme particulière aux plots correspondant aux ilots de matière accumulée lors du dépôt de la couche du matériau dans les zones évidées du motif défini par les billes. En outre, l'emploi de la technique de dépôt physique en phase vapeur peut contribuer à donner une forme particulière aux plots. Cette forme particulière peut favoriser la réduction de matière de chaque plot lors de l'étape ultérieure de gravure anisotrope. Chaque plot comporte par exemple des flancs comportant au moins une portion oblique.

Le lit de billes peut être retiré du substrat avant l'étape de gravure anisotrope, par exemple à l'aide de par la technique de lift-off avec agitation par ultrasons.

Lorsque l'on cherche à contrôler le contrôle de la recristallisation d'une couche mince de silicium à partir de germes, l'emploi de plots de siliciures métalliques selon l'invention peut permettre d'obtenir des grains de taille satisfaisante sans risque de polluer le silicium lors de la cristallisation de ce dernier à partir d'un tel plot.

Le procédé selon l'invention peut avantageusement être mis en oeuvre sur des substrats de nature chimique variée.

Ce substrat peut être de nature très diverse, organique ou inorganique, voire de nature composite c'est-à-dire formé de plusieurs matériaux distincts.

Le substrat peut ainsi être à base de silicium, de céramique, de verre, d'un métal et/ou d'un cermet et se présenter généralement sous la forme d'une plaque, d'une feuille ou d'un film.

Le substrat peut être monocristallin.

A titre d'exemple de substrats convenables, on peut notamment citer la mullite et l'alumine.

L'invention pourra être mieux comprise à la lecture qui va suivre d'un exemple non limitatif d'une mise en oeuvre de celle-ci et à l'examen du dessin annexé sur lequel :
- la figure 1 représente de façon schématique un procédé selon un exemple de mise en oeuvre de l'invention et,
- les figures 2a à 2c représentent un plot de profil à différentes étapes du procédé de la figure 1.

Le substrat sur lequel on souhaite réaliser une structure régulière de plots est par exemple une plaque d'alumine de dimension 10 X 10 cm² et de pureté 99 %. Cette plaque d'alumine peut être revêtue d'une couche barrière dont l'épaisseur est par exemple de 500 nanomètres. La couche barrière est par exemple réalisée en nitrure de tantale TaN déposé par pulvérisation cathodique magnétron.

Lors d'une étape 1, on dépose sur le substrat un lit de billes de rayon R, ce rayon R étant choisi en fonction de la distance que l'on souhaite obtenir entre deux plots, comme on le verra par la suite. Les billes déposées sont par exemple des billes de silice de rayon 1,5 micromètres. Le lit de billes peut être placé lors de l'étape 1 sur le substrat par un procédé de type trempage. A titre d'exemple, on pourra se référer au procédé divulgué dans la demande PCT WO 03/095108.

L'étape 2 correspond à un dépôt pleine plaque selon la technologie dite de dépôt physique par vapeur d'une couche nanométrique d'un matériau, dans l'exemple décrit du siliciure métallique de formule CoSi₂. Cette couche de CoSi₂ a par exemple une épaisseur de 10 nanomètres. Du fait de la présence du lit de billes définissant un motif avec des zones évidées, le siliciure se concentre dans ces dernières pour former des plots selon des ilots.

Lors d'une étape 3, le lit de billes est éliminé du substrat par exemple à l'aide de la technique *lift-off*, laissant ainsi à découvert les îlots de siliciure mentionnés ci-dessus.

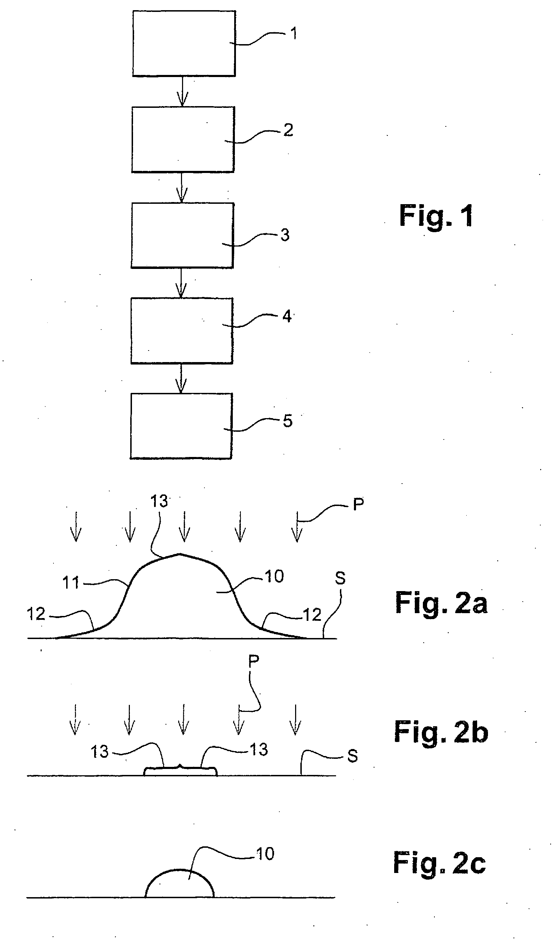

Au niveau de chaque îlot est formé un plot 10 dont on a représenté un exemple de profil à la figure 2a.

Comme on peut le voir, ces plots 10 présentent en section des flancs 11 comportant des portions 12 obliques et des portions 13 sensiblement parallèles à la surface S du substrat.

Lors de l'étape 4, ces plots 10 sont soumis à une gravure anisotrope par un plasma directif de gaz neutre, en particulier d'argon. Comme on peut le voir sur les figures 2a et 2b qui sont représentées avec des échelles différentes, le plasma P est dirigé normalement à la surface S du substrat.

La gravure anisotrope mise en oeuvre permet d'enlever essentiellement la matière au niveau des portions obliques 12 de sorte qu'à l'issue de l'étape 4, chaque plot 10 présente le profil représenté à la figure 2b, un tel profil correspondant à un profil sensiblement cylindrique.

Cette étape 4 dure par exemple vingt minutes et permet de réduire la quantité de matière présente dans chaque plot d'un facteur supérieur à cinq, étant par exemple égal ou supérieur à dix.

Lors d'une étape 5, le substrat portant ladite structure est soumis à un échauffement thermique sous atmosphère réductrice. Cette étape 5 correspond par exemple à un échauffement à 1250 °C pendant trente minutes sous une atmosphère réductrice argon avec de l'hydrogène, par exemple avec 5 % d'hydrogène. L'étape 5 d'échauffement induit une stabilisation du siliciure métallique qui se regroupe par exemple sous forme de calottes sphériques cristallines d'un diamètre d'environ 70 nanomètres pour chaque plot.

Cette étape 5 est par exemple mise en oeuvre dans un four résistif, dans un four à induction ou dans un four à lampe.

L'invention permet d'obtenir un rapport entre la taille de l'espacement entre des plots voisins de la structure et la taille des plots supérieur à 25, les plots étant disposés selon une structure régulière. Les plots obtenus ont par exemple une taille nanométrique.

L'invention n'est pas limitée aux exemples qui viennent d'être décrits.

## Revendications

1. Procédé de réalisation, à la surface d'au moins une face d'un substrat, d'une structure régulière de plots dans laquelle lesdits plots sont disposés de manière non contigüe et possèdent une taille au moins dix fois inférieure à la taille de l'espacement entre deux plots voisins de ladite structure, le procédé comportant au moins les étapes suivantes :
a) disposer d'un substrat doté en surface d'au moins l'une de ses faces d'une structure régulière de plots,
b) soumettre ladite structure figurant sur le substrat à une gravure anisotrope en présence d'un plasma directif de façon à réduire la quantité de matière de chaque plot, et
c) soumettre ladite structure à un traitement thermique à une température comprise entre T_{f}-200 °C et T_{f}-50 °C, où T_{f}est la température de fusion des plots.

2. Procédé selon la revendication précédente, dans lequel on réduit la quantité de matière de chaque plot de façon à ce que le rapport entre ladite quantité avant gravure anisotrope et ladite quantité après gravure anisotrope soit supérieur à cinq, notamment à dix.

3. Procédé selon l'une quelconque des revendications précédentes, dans lequel la structure régulière de plot obtenue est **caractérisée par** un rapport (taille de l'espacement entre deux plots voisins dans la structure)/(taille d'un plot) qui est supérieur ou égal à 25, notamment à 50, notamment à 100, à 500, voire à 1000.

4. Procédé selon l'une quelconque des revendications précédentes, dans lequel les plots obtenus possèdent une taille comprise entre 5 et 500 nm, notamment entre 20 et 500 nanomètres, notamment entre 40 et 100 nanomètres, et notamment entre 50 et 100 nm.

5. Procédé selon l'une quelconque des revendications précédentes, dans lequel la taille de l'espacement entre deux plots voisins est comprise entre 0,1 et 500 micromètres, notamment entre 2 et 50 micromètres, entre 2 et 10 micromètres, et notamment entre 5 et 10 micromètres.

6. Procédé selon l'une quelconque des revendications précédentes, dans lequel l'étape de gravure anisotrope est mise en oeuvre en présence d'un plasma directif de gaz neutre ou d'hydrogène.

7. Procédé selon la revendication précédente, dans lequel lors de l'étape de gravure anisotropique, le plasma directif est dirigé normalement au substrat.

8. Procédé selon l'une quelconque des revendications précédentes comprenant en outre une étape préalable de dépôt d'un matériau sur le substrat de manière à former la structure régulière de plots de l'étape a).

9. Procédé selon l'une quelconque des revendications précédentes, dans lequel le matériau constituant les plots est déposé avant l'étape a) sur un lit de billes placé sur le substrat, ledit lit de billes définissant un motif présentant des zones évidées.

10. Procédé selon la revendication précédente, dans lequel le matériau est déposé sur le lit de billes par dépôt physique en phase vapeur.

11. Procédé selon la revendication 9 ou 10, dans lequel le lit de billes est retiré du substrat avant l'étape de gravure anisotrope.

12. Procédé selon l'une quelconque des revendications précédentes, dans lequel les plots figurant sur le substrat sont à base de siliciure métallique.

13. Procédé selon l'une quelconque des revendications précédentes, dans lequel le substrat est monocristallin.

## Patentansprüche

1. Verfahren zur Bildung einer regelmäßigen Struktur von Kontakten auf der Oberfläche wenigstens einer Seite eines Substrats, bei dem die Kontakte einander nicht berührend angeordnet werden und eine Größe haben, die mindestens um das Zehnfache kleiner ist als die Größe des Abstands zwischen zwei benachbarten Kontakten der Struktur, welches Verfahren wenigstens die folgenden Schritte aufweist:
a) Bereitstellen eines Substrats, das an der Oberfläche wenigstens einer seiner Seiten mit einer regelmäßigen Struktur von Kontakten bestückt ist,
b) Anwenden einer anisotropen Gravur in Gegenwart eines gerichteten Plasmas auf die auf dem Substrat gebildete Struktur in der Weise, dass die Menge an Material jedes Kontakts reduziert wird, und
c) Anwenden einer thermischen Behandlung auf diese Struktur, bei einer Temperatur zwischen T_{f}- 200°C und T_{f}- 50°C, wobei T_{f} die Schmelztemperatur der Kontakte ist.

2. Verfahren nach dem vorstehenden Anspruch, bei dem man die Menge des Materials jedes Kontakts so verringert, dass das Verhältnis zwischen dieser Menge vor der anisotropen Gravur und dieser Menge nach der anisotropen Gravur größer als fünf, insbesondere größer als zehn ist.

3. Verfahren nach einem der vorstehenden Ansprüche, bei dem die erhaltene regelmäßige Struktur der Kontakte **gekennzeichnet ist durch** ein Verhältnis (Größe des Abstands zwischen zwei benachbarten Kontakten in der Struktur) / (Größe eines Kontakts), das größer oder gleich 25, insbesondere 50, 100 oder größer oder gleich 1000 ist.

4. Verfahren nach einem der vorstehenden Ansprüche, bei dem die erhaltenen Kontakte eine Größe zwischen 5 und 500 nm, insbesondere zwischen 20 und 500 nanometer, insbesondere zwischen 40 und 100 nanometer und insbesondere zwischen 50 und 100 Nanometer haben.

5. Verfahren nach einem der vorstehenden Ansprüche, bei dem die Größe des Abstands zwischen zwei benachbarten Kontakten zwischen 0,1 und 500 mikrometer beträgt, insbesondere zwischen 2 und 50 mikrometer, zwischen 2 und 10 mikrometer und insbesondere zwischen 5 und 10 mikrometer.

6. Verfahren nach einem der vorstehenden Ansprüche, bei dem der Schritt der anisotropen Gravur in Gegenwart eines gerichteten Plasmas eines Inertgases oder Wasserstoffgases ausgeführt wird.

7. Verfahren nach dem vorstehenden Anspruch, bei dem während des Schrittes der anisotropen Gravur das gerichtete Plasma senkrecht auf das Substrat gerichtet wird.

8. Verfahren nach einem der vorstehenden Ansprüche, mit einem weiteren vorangehenden Schritt der Ablagerung eines Materials auf dem Substrat aufweist, in der Weise, dass die regelmäßige Struktur der Kontakte nach Schritt a) gebildet wird.

9. Verfahren nach einem der vorstehenden Ansprüche, bei dem das Material, das die Kontakte bildet, vor dem Schritt a) auf einem Kugelbett abgelagert wird, das auf das Substrat aufgelegt ist, wobei dieses Kugelbett ein Muster mit leeren Zonen bildet

10. Verfahren nach dem vorstehenden Anspruch, bei dem das Material durch physikalische Abscheidung aus der Dampfphase auf dem Kugelbett abgelagert wird.

11. Verfahren nach Anspruch 9 oder 10, bei dem das Kugelbett vor dem Schritt der anisotropen Gravur von dem Substrat abgezogen wird.

12. Verfahren nach einem der vorstehenden Ansprüche, bei dem die auf dem Substrat gebildeten Kontakte auf einem Metallsilicid basieren.

13. Verfahren nach einem der vorstehenden Ansprüche, bei dem das Substrat monokristallin ist.

## Claims

1. Method for the provision, on the surface of at least one face of a substrate, of a regular structure of contacts, in which said contacts are arranged in a non-contiguous manner and have a size at least ten times less than the size of the space between two adjacent contacts of the same structure, the method comprising at least the following steps:
a) Providing of a substrate, provided on the surface of at least one of its faces with a regular structure of contacts,
b) Subjecting said structure provided on the substrate to an anisotropic etching in the presence of a directive plasma in such a way as to reduce the quantity of material of each contact, and
c) Subjecting said structure to a heat treatment at a temperature of between T_{f} - 200°C and T_{f} - 50 °C, where T_{f} is the fusion temperature of the contacts.

2. Method according to the foregoing claim, in which the quantity of material of each contact is reduced in such a way that the ratio between said quantity before anisotropic etching and said quantity after anisotropic etching is greater than five, in particular than ten.

3. Method according to any of the foregoing claims, in which the regular structure of contact which is obtained is **characterized by** a ratio (size of the space between two adjacent contacts in the structure) / (size of a contact) which is greater than or equal to 25, in particular to 50, in particular to 100, to 500, and even to 1000.

4. Method according to any of the foregoing claims, in which the contacts obtained have a size comprised between 5 and 500 nm, in particular between 20 and 500 nanometers, in particular between 40 and 100 nanometers, and in particular between 50 and 100 nm.

5. Method according to any of the foregoing claims, in which the size of the spacing between two adjacent contacts is comprised between 0.1 and 500 micrometers, in particular between 2 and 50 micrometers, between 2 and 10 micrometers, and in particular between 5 and 10 micrometers.

6. Method according to any of the foregoing claims, in which the step of anisotropic etching is carried out in the presence of a directive plasma of neutral gas or hydrogen.

7. Method according to the foregoing claim, in which, during the step of anisotropic etching, the directive plasma is directed normally to the substrate.

8. Method according to any of the foregoing claims, additionally comprising a preliminary step of deposit of a material on the substrate in such a way as to form the regular structure of contacts of step a).

9. Method according to any of the foregoing claims, in which the material constituting the contacts is deposited before the step a) on a bed of balls placed on the substrate, said bed of balls defining a motif presenting hollowed zones.

10. Method according to the foregoing claim, in which the material is deposited on the bed of balls by physical depositing in the vapour phase.

11. Method according to claim 9 or 10, in which the bed of balls is withdrawn from the substrate before the step of anisotropic etching.

12. Method according to any of the foregoing claims, in which the contacts featuring on the substrate are based on metallic silicide.

13. Method according to any of the foregoing claims, in which the substrate is monocrystalline.
